(19) Europäisches Patentamt / European Patent Office / Office européen des brevets

(11) **EP 3 444 625 A1**

(12) **EUROPEAN PATENT APPLICATION**
published in accordance with Art. 153(4) EPC

(43) Date of publication:
**20.02.2019 Bulletin 2019/08**

(21) Application number: **17824075.0**

(22) Date of filing: **27.06.2017**

(51) Int Cl.:
*G01R 31/36* (2019.01)     *H01M 10/44* (2006.01)
*H01M 10/48* (2006.01)     *H02J 3/32* (2006.01)
*H02J 3/38* (2006.01)     *H02J 7/00* (2006.01)

(86) International application number:
**PCT/JP2017/023552**

(87) International publication number:
**WO 2018/008469 (11.01.2018 Gazette 2018/02)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **08.07.2016 JP 2016136275**

(71) Applicant: **Kaneka Corporation
Osaka-shi, Osaka 530-8288 (JP)**

(72) Inventor: **KAWABE Masaru
Settsu-shi
Osaka 566-0072 (JP)**

(74) Representative: **V.O.
P.O. Box 87930
Carnegieplein 5
2508 DH Den Haag (NL)**

(54) **ELECTRICITY STORAGE DEVICE, ELECTRICITY STORAGE SYSTEM, AND POWER SUPPLY SYSTEM**

(57)     An electricity storage device, an electricity storage system and a power supply system capable of setting a full charge capacity corresponding to an actual full charge capacity are developed. The electricity storage device includes a battery part, and a control part that controls charge and discharge of the battery part. The battery part is capable of discharging from a full charge capacity to a preset set capacity. The control part is capable of executing a full charge capacity correction mode. The full charge capacity correction mode executes: a remaining capacity calculation operation in which, when the battery part discharges from the full charge capacity to the set capacity, a remaining capacity corresponding to a first voltage of the battery part in a state of having discharged to the set capacity is calculated based on a preset correlation between a voltage and a battery capacity of the battery part, and a consumed capacity calculation operation in which a consumed capacity consumed from the full charge capacity to the set capacity is calculated by calculating a current amount of the battery part during a time period from the full charge capacity to the set capacity. A sum of the remaining capacity and the consumed capacity is set as a full charge capacity.

FIG.5

EP 3 444 625 A1

**Description**

TECHNICAL FIELD

The present invention relates to an electricity storage device, an electricity storage system, and a power supply system. In particular, the present invention relates to a stationary type electricity storage device.

BACKGROUND ART

In recent years, in addition to a system power supply, a power supply system is developed that includes a power generating device and an electricity storage device, and is capable of supplying home-generated power to an external load. This power supply system is connected in parallel with respect to a system power supply, and generally charges the electricity storage device with power supplied from the system power supply during night when power fees are low and supplies the charged power from the electricity storage device to an external load such as a home electric appliance. By doing this, power fees can be reduced. Further, an electricity storage device that stores power includes built-in secondary battery groups that each include multiple secondary batteries connected in series. In such an electricity storage device, by connecting the multiple secondary batteries in series, a voltage can be increased and it is possible to perform charge and discharge with larger power.

PRIOR ART DOCUMENTS

PATENT DOCUMENTS

Patent Document 1: Japanese Patent Laid-Open Publication No. 2016-25760.

DISCLOSURE OF INVENTION

TECHNICAL PROBLEM

However, in the secondary batteries built in the electricity storage device, when a constituent material of the secondary batteries deteriorates due to long-term use, a battery capacity decreases, and a difference between an actual full charge capacity and a factory full charge capacity occurs. Therefore, when operation continues with settings of the factory full charge capacity, charge or discharge that is not in accordance with the actual full charge capacity is executed, and there is a risk that, in some cases, overdischarge or overcharge may occur. When overdischarge or overcharge occurs, there is a problem that the deterioration of the constituent material of the secondary batteries is promoted, and further, lives of the secondary batteries are shortened. In particular, in the electricity storage device having the built-in secondary battery groups that each include multiple secondary batteries connected in series, even when identical secondary batteries are used, individual differences between the secondary batteries in the secondary battery groups occur during manufacturing. Therefore, there is also a problem that overdischarge or overcharge is likely to occur in a secondary battery having a small capacity in the secondary battery groups.
Therefore, the present invention is intended to provide an electricity storage device, an electricity storage system and a power supply system capable of setting a full charge capacity corresponding to an actual full charge capacity.

SOLUTION TO PROBLEM

One aspect of the present invention for solving the above problem is an electricity storage device that includes a battery part, and a control part that controls charge and discharge of the battery part. The battery part is capable of discharging from a full charge capacity to a preset set capacity. The control part is capable of executing a full charge capacity correction mode. The full charge capacity correction mode executes: a remaining capacity calculation operation in which, when the battery part has discharged from the full charge capacity to the set capacity, a remaining capacity corresponding to a first voltage of the battery part in a state of having discharged to the set capacity is calculated based on a preset correlation between a voltage and a battery capacity of the battery part; and a consumed capacity calculation operation in which a consumed capacity consumed from the full charge capacity to the set capacity is calculated by calculating a current amount of the battery part during a time period from the full charge capacity to the set capacity. A sum of the remaining capacity and the consumed capacity is set as a full charge capacity.
Here, "the current amount" includes not only a positive current amount but also a negative current amount. For example, when a current amount due to discharging is +i [A], a current amount due to charging is -i [A].
Here, "the full charge capacity" is a charge capacity in a state that is considered as a fully charged state based on a predetermined criterion.

Here, "the first voltage at the set capacity" refers to a voltage of the entire or a part of the battery part at the set capacity. That is, "the first voltage at the set capacity" refers to a voltage of the entire battery part when the battery part is formed by a single battery, and refers to not only a voltage of the entire battery part but also voltages of individual batteries or a group of voltages when the battery part is formed by multiple batteries.

According to this aspect, the full charge capacity correction mode, using that the battery part has discharged from the full charge capacity to the set capacity as a condition, separately executes the remaining capacity calculation operation in which the remaining capacity is calculated and the consumed capacity calculation operation in which the consumed capacity is calculated, and adds up the calculation results of the remaining capacity calculation operation and the consumed capacity calculation operation and newly sets the result of the addition as an actual full charge capacity. That is, in the remaining capacity calculation operation, the remaining capacity as the charge capacity is calculated using a preset correlation between a voltage and a battery capacity of the battery part, and further, in the consumed capacity calculation operation, a change in the battery part is monitored and the consumed capacity is calculated based on a criterion different from that of the remaining capacity calculation operation, and a full charge capacity is newly set. Therefore, a full charge capacity corresponding to a decrease in the capacity of the battery part due to deterioration of the battery part can be accurately set and control can be performed accordingly. Therefore, overvoltage and overcharge can be prevented.

A preferred aspect is that the full charge capacity correction mode is executed when the battery part executes only discharging from the full charge capacity to the set capacity.

According to this aspect, the full charge capacity correction mode is performed when only discharging from the full charge capacity to the set capacity is executed, and the actual full charge capacity can be set in a state in which an effect due to a change in capacity due to charging is excluded. Therefore, the full charge capacity can be more accurately set.

A preferred aspect is that the control part has a voltage detection means that detects a voltage of the battery part, and, in a state in which a current balance in the battery part is set to substantially 0 and the set capacity is maintained, obtains as the first voltage of the battery part after a predetermined time period has elapsed since the set capacity is reached.

Here, "the current balance in the battery part is set to substantially 0" means that a charge current to the battery part and a discharge current from the battery part are limited to a negligible level, and, specifically, means that the charge current to the battery part and the discharge current from the battery part are limited to 0.01 C or less.

Here, "1 C" refers to a value of a current for completing discharging by constant-current discharging for 1 hour. That is, "0.01 C" is a value of a current for completing discharging by constant-current discharging for 100 hours.

According to this aspect, the first voltage is measured after the predetermined time period has elapsed in a state in which the current balance in the battery part is set to substantially 0. Therefore, since a pseudo open circuit potential (hereinafter, also referred to as "OCV") at the set capacity in a stable state can be obtained, a measured value is unlikely to fluctuate, and the actual charge capacity is easy to be calculated.

A more preferred aspect is that the battery part includes multiple secondary battery groups that are connected in series; the voltage detection means is capable of detecting voltages of the secondary battery groups; in a state in which the current balance in the battery part is set to substantially 0 and a state of the set capacity is maintained, the control part obtains a minimum voltage of the secondary battery groups after a predetermined time period has elapsed since the set capacity is reached; and in the remaining capacity calculation operation, the remaining capacity is calculated based on the first voltage and the minimum voltage.

According to this aspect, since the remaining capacity is calculated based on the minimum voltage of the secondary battery groups in the battery part in addition to the first voltage in the pseudo open circuit state, the full charge capacity based on the minimum voltage of the secondary battery groups in the battery part can be set.

A preferred aspect is that the battery part includes multiple secondary battery groups that are connected in series; the control part repeatedly executes the full charge capacity correction mode; and the full charge capacity correction mode is performed when a predetermined time period has elapsed since a previous full charge capacity is set and when only discharging from the full charge capacity to the set capacity is executed.

According to this aspect, the full charge capacity correction mode is executed in a state in which a predetermined time period is provided between executions of the full charge capacity correction mode and when only discharging is executed. Therefore, the full charge capacity correction mode is unlikely to interfere with normal operation.

A preferred aspect is that, in the consumed capacity calculation operation, the consumed capacity is calculated by integrating a current amount of the battery part from the full charge capacity to the set capacity.

According to this aspect, the consumed capacity consumed between the full charge capacity and the set capacity can be more accurately calculated.

One aspect of the present invention is an electricity storage system that includes the above-described electricity storage device, and a power conversion device that converts between AC power and DC power, and is capable of being electrically connected to a power generating device, and is capable of charging the electricity storage device with power generated by the power generating device.

According to this aspect, since the power generated by the power generating device can be stored by the electricity storage device, electricity fees and the like to be paid by a user can be reduced.

In a preferred aspect, the power conversion device is capable of being electrically connected to a system power supply, and is capable of converting AC power supplied from the system power supply to DC power to be used to charge the electricity storage device.

According to this aspect, since the AC power supplied from the system power supply can be converted to DC power to be used to charge the electricity storage device, for example, charging can be performed during a time period when electricity fees are low, and electricity stored by the electricity storage device can be used during a time period when electricity fees are high. Therefore, electricity fees and the like to be paid by a user can be reduced.

One aspect of the present invention is a power supply system that includes the above-described electricity storage device, and a display device capable of obtaining and displaying information about power of the electricity storage device. The control part, in a state in which a current balance in the battery part is set to substantially 0 and the set capacity is maintained, obtains as the first voltage of the battery part after a predetermined time period has elapsed since the set capacity is reached. The display device, in the full charge capacity correction mode, does not update the information about the power of the electricity storage device during a predetermined time period after the battery part has reached the set capacity.

Here, "the information about the power" refers to a voltage, a current, power, a charge capacity and the like.

According to this aspect, the display device capable of obtaining and displaying the information about the power of the electricity storage device is provided. Therefore, a user can visually confirm the information about the power of the electricity storage device and can grasp a current state of the electricity storage device.

Here, theoretically, when the set capacity is maintained in the state in which the current balance in the battery part is set to substantially 0, since the current balance is 0, a constant voltage should be exhibited.

However, in practice, immediately after executing only discharging to the set capacity, the voltage tends to fluctuate. Therefore, since the information linked to the voltage changes with the change in the voltage, there is a possibility that, when a user sees the display of the information linked to the voltage, the user may feel that a failure or the like may have occurred.

Therefore, according to this aspect, in the full charge capacity correction mode, the display device does not update the information about the power of the electricity storage device during a predetermined time period after the battery part reaches the set capacity. Therefore, a user is prevented from feeling that a failure or the like may have occurred when the user sees the information displayed in the display device.

EFFECT OF INVENTION

According to the present invention, a full charge capacity corresponding to an actual full charge capacity can be set.

BRIEF DESCRIPTION OF DRAWINGS

Fig. 1 is a block diagram illustrating a power supply system of a first embodiment of the present invention.

Fig. 2 is a block diagram an electricity storage device of Fig. 1.

Fig. 3 is a flowchart from a normal operation mode to transitioning to a full charge capacity correction mode of the electricity storage device of Fig. 1.

Fig. 4 is a flowchart of the full charge capacity correction mode of the electricity storage device of Fig. 3.

Fig. 5 is a graph illustrating a correlation between a charge rate and an open circuit potential of secondary battery groups of the electricity storage device of Fig. 3.

Fig. 6 is a graph illustrating typical voltage transition in the full charge capacity correction mode of the electricity storage device of Fig. 3.

BEST MODE FOR CARRYING OUT THE INVENTION

A power supply system 1 of a first embodiment of the present invention is a power supply system that is mainly provided in a house or a building and forms a power supply for an external load 100 such as an electric appliance. That is, the power supply system 1 is a stationary type power supply system that is used by being fixed at a desired position.

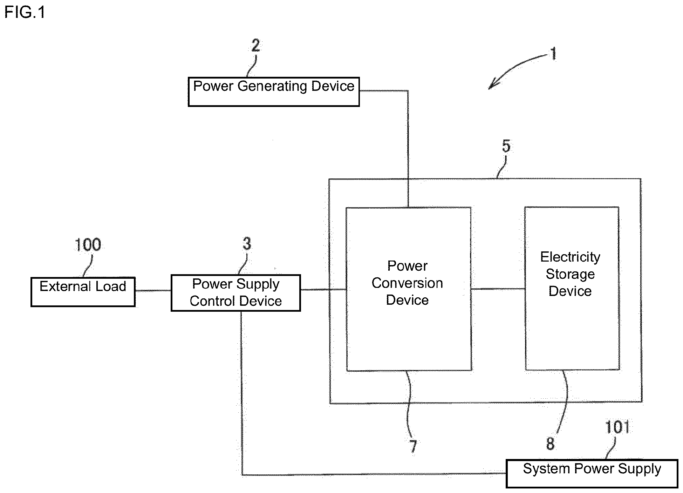

As illustrated in Fig. 1, the power supply system 1 includes a power generating device 2, a power supply control device 3, a display device (not illustrated in the drawings), and an electricity storage system 5. The power supply system 1 is connected to the external load 100 and a system power supply 101 via the power supply control device 3, and supplies power supplied from a system power supply 101, which is a commercial power supply supplied from a power company or the like, to the external load 100.

The power generating device 2 is a power generating device such as a solar cell module or a fuel cell module, and is a device serving as a power supply other than the system power supply 101.

The power supply control device 3 is a device capable of switching power supply to the external load 100 between the system power supply 101 and the electricity storage system 5.

The display device is a device displaying information about power of the power generating device 2 or power of an electricity storage device 8, and is capable of displaying a current-voltage curve or the like of the power generating device 2 or the electricity storage device 8.

As illustrated in Fig. 1, the electricity storage system 5 includes a power conversion device 7 and the electricity storage device 8.

The power conversion device 7 is a so-called power conditioner and is capable of converting AC power to DC power. That is, the power conversion device 7, by being electrically connected to the power generating device 2, is capable of converting DC power generated by the power generating device 2 to AC power and supplying the AC power to the power supply control device 3, and, by being electrically connected to the system power supply 101, is capable of converting AC power supplied from the system power supply 101 to DC power and supplying the DC power to the electricity storage device 8.

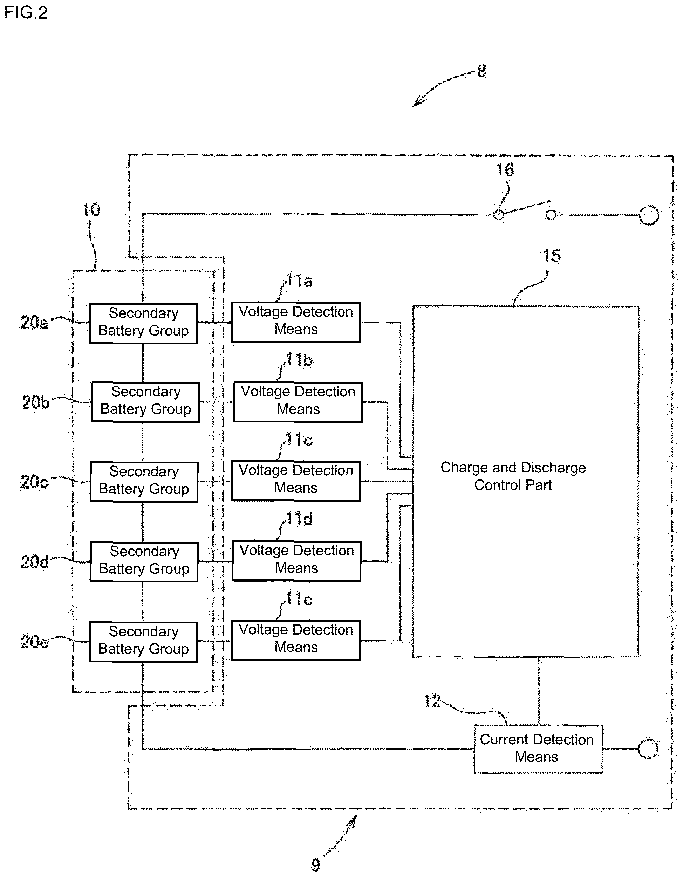

The electricity storage device 8 temporarily stores the power generated by the power generating device 2 and the power supplied from the system power supply 101. As illustrated in Fig. 2, the electricity storage device 8 has a secondary battery unit 10 (battery part) and a control unit 9 (control part).

The secondary battery unit 10 includes multiple secondary battery groups (20a - 20e) that are electrically connected in series. As illustrated in Fig. 2, the secondary battery unit 10 of the present embodiment is formed by five secondary battery groups (20a - 20e).

The secondary battery groups (20a - 20e) are each formed by electrically connecting multiple secondary batteries in series.

The control unit 9 controls charge and discharge of the secondary battery unit 10, and includes, as main components, multiple voltage detection means (11a - 11e) (voltage information detection means), a current detection means 12 (current information detection means), a charge and discharge control part 15, and a switching part 16.

The voltage detection means (11a - 11e) are members that are respectively provided corresponding to the secondary battery groups (20a - 20e) and respectively detect voltages of the secondary battery groups (20a - 20e), and can independently detect the voltages of the secondary battery groups (20a - 20e).

The current detection means 12 is a device that detects charge and discharge currents of the secondary battery unit 10, and is also a device that detects a total current amount passing through the secondary battery unit 10.

The current detection means 12 of the present embodiment detects a discharge current as a positive current and a charge current as a negative current. That is, the current detection means 12 detects a current of "+1 A" when a discharge current of 1 A flows, and detects a current of "-1 A" when a charge current of 1 A flows.

The charge and discharge control part 15 is a charge and discharge control device that controls charge and discharge of the secondary battery unit 10, and a remaining capacity management device that manages a remaining capacity of the secondary battery unit 10.

The charge and discharge control part 15 is also a processing unit that is connected to the voltage detection means (11a - 11e) and the current detection means 12 by wireless or wired connections, and is capable of performing predetermined arithmetic processing based on information detected by the voltage detection means (11a - 11e) and the current detection means 12. Further, the charge and discharge control part 15 is also a current amount integration part capable of executing integration processing in which a current amount detected by the current detection means 12 is integrated.

Specifically, the charge and discharge control part 15 includes a CPU (central processing unit) that performs various kinds of arithmetic processing, a ROM as a main memory, a RAM for temporarily storing various kinds of data, a communication I/F, and a storage device such as a HDD (hard disk drive).

The switching part 16 is a switch that switches between electrical connection and disconnection with respect to the power conversion device 7.

The electricity storage device 8 is capable of executing a normal operation mode in which a charge operation to perform charging with the power generated by the power generating device 2 and a discharge operation to discharge stored power to the external load 100 side are performed.

In the normal operation mode, in the discharge operation, setting is performed such that a voltage does not become equal to or lower than a preset battery capacity, and in the charge operation, setting is performed such that a voltage does not become equal to or higher than a preset voltage.

Further, in addition to the normal operation mode, the electricity storage device 8 is capable of repeatedly executing a full charge capacity correction mode in which, by satisfying a predetermined condition, an actual full charge capacity (hereinafter, also referred to as FCC) is updated or reset based on decreases in capacities of the secondary batteries of the secondary battery groups (20a - 20e).

As described above, the full charge capacity correction mode is a correction mode that the electricity storage device 8 transitions to when the electricity storage device 8 in a state of operating in the normal operation mode satisfies a predetermined condition.

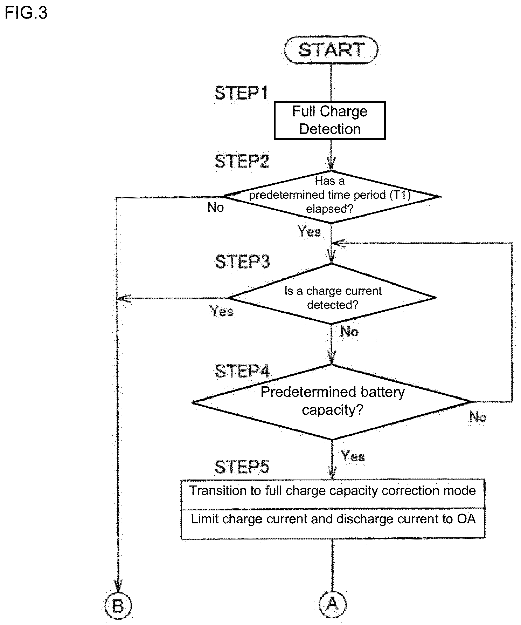

Specifically, the full charge capacity correction mode transitions as follows based on the flowchart of Fig. 3.

That is, when the electricity storage device 8 is operating in the normal operation mode and it is detected that the secondary battery unit 10 is in a fully charged state due to charging (STEP 1, full charge detection process), whether or not a predetermined time period (T1) has elapsed since initial activation or after performing the full charge capacity correction mode last time is determined (STEP 2).

Here, in the power supply system 1 of the present embodiment, as a method for detecting the fully charged state, the detection is performed by satisfying either one of the following two criteria.

Specifically, as the first criterion, when a maximum voltage (Vmax) of the secondary battery groups (20a - 20e) forming the secondary battery unit 10 reaches a predetermined voltage, the fully charged state is detected.

As the second criterion, when a total voltage of the secondary battery groups (20a - 20e) reaches a predetermined voltage, the fully charged state is detected.

These "predetermined voltages" are preset voltages corresponding to predetermined charge rates, and are voltages that are threshold values of charging. Naturally, the former and the latter of these values are different from each other.

Further, the "predetermined time period (T1)" is a time period in which some change is expected to have occurred to the full charge capacity of the secondary battery unit 10. The "predetermined time period (T1)" is preferably set to 20 days or more from a point of view of an execution frequency, and is preferably set to 90 days or less from a point of view of preventing an overvoltage or the like due to inconsistency in the full charge capacity.

In the present embodiment, the "predetermined time period (T1)" is set to 30 days.

When the predetermined time period (T1) has elapsed since the initial activation or after performing the full charge capacity correction mode last time, that is, after setting the past full charge capacity (Yes at STEP 2), and further a charge current is not detected (No at STEP 3), similar to the normal operation mode, based on a power demand from the external load 100, discharge is performed until a predetermined battery capacity (hereinafter, also referred to as a "set capacity") that is preset on the external load 100 side is reached.

In this case, a voltage applied to the secondary battery unit 10 and a current passing through the secondary battery unit 10 are monitored by the voltage detection means (11a - 11e) and the current detection means 12.

Here, the set capacity is preferably 10% or more and 50% or less, and more preferably 20% or more and 40% or less of the initially set full charge capacity or the full charge capacity set in the full charge capacity correction mode performed last time. That is, a charge rate (hereinafter, also referred to as an "SOC"), which is a ratio of an amount of charged electricity to an electric capacity at an OCV, is preferably 10% or more and 50% or less, and more preferably 20% or more and 40% or less.

When the charge rate is within this range, in a consumed capacity calculation operation (to be described later), a consumed capacity (DCR) can be more accurately calculated.

In the present embodiment, the charge rate corresponding to the OCV is set to be 30% of the fully charged state.

Then, when a charge current is not detected until a preset set capacity is reached (No at STEP 3) and having discharged to the set capacity is detected (Yes at STEP 4, discharge termination detection process), the process transitions to the full charge capacity correction mode, and a charge current and a discharge current are limited to substantially 0 A (STEP 5). That is, a current balance from outside of the electricity storage device 8 is set to substantially 0 A, and a pseudo open circuit state is formed.

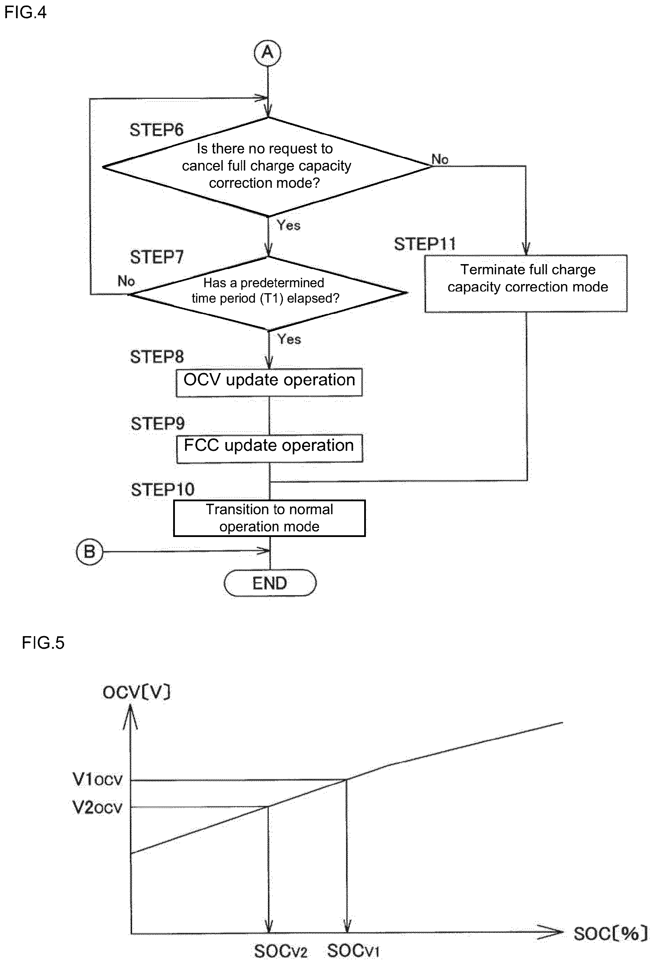

When the process transitions to the full charge capacity correction mode, as illustrated in the flowchart of Fig. 4, while confirming whether or not there is a request to cancel the full charge capacity correction mode (STEP 6), in a state in which there is no request to cancel the full charge capacity correction mode, the process waits until a predetermined time period (T2) has elapsed (STEP 7). That is, without performing a charge or discharge operation for the secondary battery unit 10, in a state in which a current balance is set to substantially 0 A and the set capacity is maintained, the process waits until the predetermined time period (T2) has elapsed.

The predetermined time period (T2) is a time period until the OCV is sufficiently stable, and is preferably 100 minutes or more and 200 minutes or less, and even more preferably 120 minutes or more and 180 minutes or less. In the present embodiment, the predetermined time period (T2) is 150 minutes.

In the electricity storage device 8 of the present embodiment, a time period (T3) is provided in which states of the current and voltage of the secondary battery unit 10 are not displayed in the display device since the battery capacity has reached the set capacity. That is, in the display device, during the time period (T3), images, characters or the like of states of previous current and voltage are still displayed, and images, characters or the like of states of actual current and voltage are not displayed.

The time period (T3) is preferably 10 seconds or more and 20 seconds or less. In the present embodiment, the time period (T3) is 15 seconds.

When there is no request to cancel the full charge capacity correction mode and the predetermined time period (T2) has elapsed in the state in which the set capacity is maintained (Yes at STEP 7), an OCV update operation is performed in which a voltage (first voltage) of the secondary battery unit 10 and voltages (first voltages) of the secondary battery groups (20a - 20e) are detected and obtained (battery voltage detection process) and information about the OCV (to be described later) is updated (STEP 8). Following the OCV update operation, an FCC update operation is performed in which information about the full charge capacity is updated (STEP 9). Then, when the FCC update operation is completed, the process transitions to the normal operation mode and returns to the normal operation mode (STEP 10).

At STEP 2, when the predetermined time period (T1) has not elapsed since the last full charge (No at STEP 2), it is determined that it is not necessary to transition to the full charge capacity correction mode, and the operation in the normal operation mode continues.

At STEP 3, when a charge current is detected (Yes at STEP 3), charging is performed without transitioning to the full charge capacity correction mode, and the operation in the normal operation mode continues.

At STEP 6, when there is a request to cancel the full charge capacity correction mode (No at STEP 6), the full charge capacity correction mode is terminated (STEP 11), and the process transitions to the normal operation mode (STEP 10).

Here, the OCV update operation is described.

In the OCV update operation, a charge rate ($SOC_{ocv}$) and a remaining capacity (RC) are calculated by performing calculations of the following mathematical formulas (1) and (2), and the charge rate ($SOC_{OCV}$) is reset.

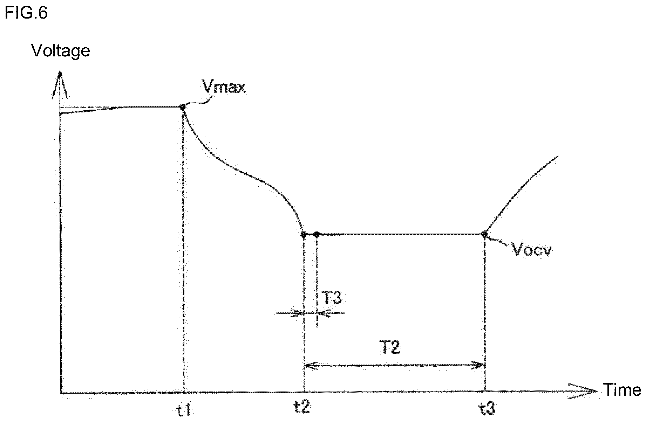

Specifically, first, an open circuit voltage ($V_{OCV}$) of the whole secondary battery unit 10 at a time (t3) illustrated in Fig. 6 is obtained by the voltage detection means (11a - 11e) and/or the current detection means 12, and an average voltage ($V2_{OCV}$) of open circuit voltages of the secondary battery groups (20a - 20e) is calculated from the open circuit voltage ($V_{ocv}$). Then, an actual charge rate ($SOC_{V2}$) of the secondary battery unit 10 is calculated from a correlation table (see Fig. 5) that represents a correlation between an open circuit voltage (OCV) and a charge rate (SOC) and is stored in advance in the storage device of the charge and discharge control part 15.

Further, the open circuit voltage of the secondary battery groups (20a - 20e) at the time (t3) illustrated in Fig. 6 are measured by the voltage detection means (11a - 11e), and a minimum voltage ($V_{min}$) among the open circuit voltages of the secondary battery groups (20a - 20e) in the secondary battery unit 10 is obtained.

Then, a charge rate ($SOC_{OCV}$) of an open circuit state is calculated according to the following mathematical formula (1) using an average voltage ($V1_{OCV}$) and a charge rate ($SOC_{V1}$) of the secondary battery groups (20a - 20e) that are initially set in advance or are reset in the full charge capacity correction mode last time. That is, the charge rate ($SOC_{OCV}$) of the actual open circuit state is calculated using the previous average voltage ($V1_{OCV}$) of the secondary battery groups (20a - 20e) corresponding to the time (t3) illustrated in Fig. 6 and using the charge rate ($SOC_{V1}$) which is a ratio of an amount of charged electricity to the electric capacity at the OCV set in the full charge capacity correction mode last time.

[Mathematical Formula 1]

$$SOC_{OCV} = \frac{(V_{min} - V1_{OCV})(SOC_{V2} - SOC_{V1})}{V2_{OCV} - V1_{OCV}} + SOC_{V1} \cdots (1)$$

When the charge rate ($SOC_{OCV}$) of the actual open circuit state is calculated according to the above mathematical formula (1), a remaining capacity (RC) is calculated according to the mathematical formula (2) using an initially set full charge capacity (FCC1) or a full charge capacity (FCC1) that is updated or reset in the full charge capacity correction mode last time (remaining capacity calculation operation). That is, according to the mathematical formula (2), an actual charge capacity in the open circuit state at the time (t3) this time is calculated.

[Mathematical Formula 2]

$$RC = FCC1 \times \frac{SOC_{OCV}}{100} \quad \cdots (2)$$

Next, the FCC update operation is described.

In the FCC update operation, using the remaining capacity (RC) calculated by the above-described OCV update operation and the consumed capacity (DCR) which is an integrated value of an current amount from the start of discharge from the fully charged state until the set capacity is reached, a full charge capacity (FCC2) is calculated by performing calculations of the following mathematical formulas (3) and (4), and this full charge capacity (FCC2) is used to update or reset the FCC1 to be used later.

Specifically, using the following mathematical formula (3), a current amount from a time (t1) at which discharge is started after the fully charged state is reached to a time (t2) at which the set capacity is reached is integrated, and a consumed capacity (DCR) consumed from the start of the discharge until the remaining capacity (RC) is reached is calculated (consumed capacity calculation operation).

Then, using the following mathematical formula (4), the remaining capacity (RC) calculated by the remaining capacity calculation operation and the consumed capacity (DCR) calculated by the consumed capacity calculation operation are added up, and the full charge capacity is updated or reset with the actual full charge capacity (FCC2).

[Mathematical Formula 3]

$$DCR = \int_{t1}^{t2} idt \quad \cdots (3)$$

[Mathematical Formula 4]

$$FCC2 = RC + DCR \quad \cdots (4)$$

Next, a relation of electrical connection between the members of the power supply system 1 is described.

As illustrated in Fig. 1, the power generating device 2 is connected to the electricity storage device 8 via the power conversion device 7. Therefore, the electricity storage device 8 can be directly charged with the DC power generated by the power generating device 2.

The power generating device 2 is electrically connected to the external load 100 via the power conversion device 7 and the power supply control device 3. Therefore, the DC power generated by the power generating device 2 can be converted to AC power by the power conversion device 7 to be supplied to the external load 100.

The electricity storage device 8 is electrically connected to the external load 100 via the power conversion device 7 and the power supply control device 3. Therefore, the DC power stored in the electricity storage device 8 can be converted to AC power by the power conversion device 7 to be supplied to the external load 100.

The electricity storage device 8 is electrically connected to the system power supply 101 via the power conversion device 7 and the power supply control device 3. Therefore, the AC power supplied from the system power supply 101 can be converted to DC power by the power conversion device 7 to be stored in the electricity storage device 8. In other words, the electricity storage device 8 can be charged with the AC power supplied from the system power supply 101 as DC power.

According to the electricity storage device 8 of the present embodiment, the full charge capacity correction mode is performed under a condition that only discharging is performed from the full charge capacity to the set capacity; the current remaining capacity (RC) is calculated by comparing the initially set OCV or the previous OCV with the current OCV; the consumed capacity (DCR) is calculated by integrating a current amount from when the fully charged state is reached until when a predetermined SOC state is reached; and the actual full charge capacity is updated or reset with the sum of the remaining capacity (RC) and the consumed capacity (DCR).

That is, the actual full charge capacity is set by respectively calculating the consumed capacity (DCR) and the remaining capacity (RC) based on different independent criteria. Therefore, the actual full charge capacity corresponding to a decrease in the capacity of the secondary battery unit 10 due to deterioration of the secondary battery unit 10 can be set. Further, since control in accordance with the actually measured and set full charge capacity can be performed, overvoltage and overcharge of the secondary battery groups (20a - 20e) can be prevented. Therefore, in the electricity storage device 8, a large number of secondary batteries can be mounted, and a large-capacity secondary battery unit 10 can be contained.

In the above embodiment, a case is described where, when the full charge capacity correction mode is performed, the full charge capacity, the OCV, the SOC and the like are always updated. However, the present invention is not limited to this. For example, in the full charge capacity correction mode, when there is substantially no change in the OCV as compared to the past OCV or when the OCV has increased as compare to the past OCV, it is not necessary to update the full charge capacity, the OCV, the SOC and the like.

As an application of the above embodiment, a deterioration state (SOH) may be calculated based on the FCC calculated based on the full charge capacity correction mode. The SOH can be calculated by dividing the FCC by a design capacity (DC).

In the above embodiment, after the battery capacity reaches the predetermined battery capacity ($SOC_{V2}$), the time period (T3) is provided in which the states of the current and the voltage of the secondary battery unit 10 are not updated in the display device. However, the present invention is not limited to this. It is also possible that the states of the current and the voltage of the secondary battery unit 10 are always displayed or are always not displayed in the display device. Further, a screen different from the states of the current and the voltage may be displayed.

In the above embodiment, in the full charge capacity correction mode, the charge current and the discharge current to the secondary battery unit 10 are limited to substantially 0 A by a program. However, the present invention is not limited to this. It is also possible that the secondary battery unit 10 is electrically disconnected from the power conversion device 7 by the switching part 16, and an open circuit is formed, and the charge current and the discharge current are limited to 0 A.

In the above embodiment, the voltage detection means (11a - 11e) are provided respectively corresponding to the secondary battery groups (20a - 20e), and the voltage detection means (11a - 11e) only perform detection of the voltages of the secondary battery groups (20a - 20e), and the OCV update operation is performed by the charge and discharge control part 15. However, the present invention is not limited to this. It is also possible that, similar to the charge and discharge control part 15, the voltage detection means (11a - 11e) each include a CPU (central processing unit) that performs various kinds of arithmetic processing, a ROM as a main memory, a RAM for temporarily storing various kinds of data, a communication I/F, and a storage device such as a HDD (hard disk drive), and an OCV update operation is performed by each of the voltage detection means (11a - 11e).

In the above embodiment, the voltages of the secondary battery groups (20a - 20e) are directly detected by the voltage detection means (11a - 11e). However, the present invention is not limited to this. It is also possible that information about the voltages of the secondary battery groups (20a - 20e) is detected by the voltage detection means (11a - 11e), and the voltages are indirectly detected.

Here, "the information about the voltages" refers to information that contains one-to-one correspondences with respect to the voltages.

In the above embodiment, the secondary battery unit 10 has five secondary battery groups (20a - 20e). However, the present invention is not limited to this. The number of the secondary battery groups 20 in the secondary battery unit 10 is not particularly limited. That is, the number of the secondary battery groups 20 in the secondary battery unit 10 may be one, or may be two or more.

In the above embodiment, the secondary battery groups 20 are each formed by multiple secondary batteries. However, the present invention is not limited to this. It is also possible that the secondary battery groups 20 are each formed of a single secondary battery.

In the above embodiment, discharge is performed from the full charge capacity until the set capacity is reached based on a power demand from the external load 100, and proceeds in accordance with a discharge environment. However, the present invention is not limited to this. For example, it is also possible that, in accordance with power supply to a power company or the like, discharge is forcibly performed from the full charge capacity until the set capacity is reached.

In the above embodiment, the battery capacity is consumed by monotonically discharging from the full charge capacity to the set capacity. However, the present invention is not limited to this. It is also possible that charging is performed during from the full charge capacity to the set capacity. In this case, in the consumed capacity calculation operation, a current amount at a time of discharging is taken as a positive current amount and a current amount at a time of charging is taken as a negative current amount, and current amounts from a time (t1) at which discharging is started after the fully charged state is reached to a time (t2) at which the set capacity is reached are integrated.

In the above embodiment, to detect the fully charged state, the voltage of the entire secondary battery unit 10 and the voltages of the individual secondary battery groups (20a - 20e) are used. However, the present invention is not limited to this. It is also possible that the fully charged state is detected based on only the voltage of the entire secondary battery unit 10, or the fully charged state is detected based on only the voltages of the individual secondary battery groups (20a - 20e). Further, it is also possible that the fully charged state is detected using other commonly known methods for detecting the fully charged state.

In the above embodiment, the actual charge rate ($SOC_{V2}$) of the secondary battery unit 10 is calculated from the correlation table (Fig. 5 illustrates the correlation table as a graph) that represents a correlation between an open circuit voltage and a charge rate and is stored in advance in the storage device of the charge and discharge control part 15. However, the present invention is not limited to this. It is also possible that the actual charge rate ($SOCv_2$) of the secondary battery unit 10 is calculated from correlation data that represents a correlation between an open circuit voltage and a charge rate and is stored in advance in the storage device of the charge and discharge control part 15.

In the above embodiment, current amounts detected by the current detection means 12 during discharging are always integrated, and the remaining capacity (RC) is calculated. However, the present invention is not limited to this. It is also possible that results obtained by respectively multiplying current amounts detected by the current detection means 12 at predetermined time intervals by elapsed time periods are integrated.

In the above embodiment, when the full charge capacity correction mode has been performed multiple times, whether or not the predetermined time period (T1) has elapsed since the full charge capacity correction mode is performed last time is determined. However, a reference date of the predetermined time period (T1) does not necessarily have to be the full charge capacity correction mode performed last time, and it is also possible that a full charge capacity correction mode performed before the full charge capacity correction mode performed last time is used as a reference. That is, it is also possible that the full charge capacity correction mode is performed when a predetermined time period has elapsed after the setting of the full charge capacity performed in the past at a time earlier than the last time and only discharging from the currently set full charge capacity to the set capacity is executed.

In the above embodiment, constituent members can be freely replaced or added between embodiments as long as the embodiments are included in the technical scope of the present invention.

EXPLANATION OF REFERENCE SIGNS

| | |
|---|---|
| 1: | power supply system |
| 2: | power generating device |
| 3: | power supply control device |
| 5: | electricity storage system |
| 7: | power conversion device |
| 8: | electricity storage device |
| 9: | control unit (control part) |
| 10: | secondary battery unit (battery part) |
| 11a - 11e: | voltage detection means (voltage information detection means) |
| 12: | current detection means |
| 15: | charge and discharge control part |
| 16: | switching part |
| 20a - 20e: | secondary battery groups |

**Claims**

1. An electricity storage device comprising:

a battery part; and
a control part that controls charge and discharge of the battery part, wherein
the battery part is capable of discharging from a full charge capacity to a preset set capacity,

the control part is capable of executing a full charge capacity correction mode,
the full charge capacity correction mode executes:

> a remaining capacity calculation operation in which, when the battery part has discharged from the full charge capacity to the set capacity, a remaining capacity corresponding to a first voltage of the battery part in a state of having discharged to the set capacity is calculated based on a preset correlation between a voltage and a battery capacity of the battery part; and
> a consumed capacity calculation operation in which a consumed capacity consumed from the full charge capacity to the set capacity is calculated by calculating a current amount of the battery part during a time period from the full charge capacity to the set capacity, and
> a sum of the remaining capacity and the consumed capacity is set as a full charge capacity.

2. The electricity storage device according to claim 1, wherein
the full charge capacity correction mode is executed when the battery part executes only discharging from the full charge capacity to the set capacity.

3. The electricity storage device according to claim 1 or 2, wherein
the control part has a voltage detection means that detects a voltage of the battery part, and, in a state in which a current balance in the battery part is set to substantially 0 and the set capacity is maintained, obtains as the first voltage of the battery part after a predetermined time period has elapsed since the set capacity is reached.

4. The electricity storage device according to claim 3, wherein
the battery part includes multiple secondary battery groups that are connected in series, the voltage detection means is capable of detecting voltages of the secondary battery groups,
in a state in which the current balance in the battery part is set to substantially 0 and a state of the set capacity is maintained, the control part obtains a minimum voltage of the secondary battery groups after a predetermined time period has elapsed since the set capacity is reached, and
in the remaining capacity calculation operation, the remaining capacity is calculated based on the first voltage and the minimum voltage.

5. The electricity storage device according to any one of claims 1 - 4, wherein
the battery part includes multiple secondary battery groups that are connected in series, the control part repeatedly executes the full charge capacity correction mode, and
the full charge capacity correction mode is performed when a predetermined time period has elapsed since a previous full charge capacity is set and when only discharging from the full charge capacity to the set capacity is executed.

6. The electricity storage device according to any one of claims 1 - 5, wherein
in the consumed capacity calculation operation, the consumed capacity is calculated by integrating a current amount of the battery part from the full charge capacity to the set capacity.

7. An electricity storage system comprising:

> the electricity storage device according to any one of claims 1 - 6; and
> a power conversion device that converts between AC power and DC power, and
> being capable of being electrically connected to a power generating device, and
> being capable of charging the electricity storage device with power generated by the power generating device.

8. The electricity storage system according to claim 7, wherein
the power conversion device is capable of being electrically connected to a system power supply, and is capable of converting AC power supplied from the system power supply to DC power to be used to charge the electricity storage device.

9. A power supply system comprising:

> the electricity storage device according to any one of claims 1 - 6; and
> a display device capable of obtaining and displaying information about power of the electricity storage device, wherein
> the control part, in a state in which a current balance in the battery part is set to substantially 0 and the set capacity is maintained, obtains as the first voltage of the battery part after a predetermined time period has elapsed since the set capacity is reached, and
the display device, in the full charge capacity correction mode, does not update the information about the power of the electricity storage device during a predetermined time period after the battery part has reached the set capacity.

FIG.1

FIG.2

FIG.3

```
                              ┌─────────┐
                              │  START  │
                              └────┬────┘
                                   │
STEP1                         ┌────▼─────┐
                              │Full Charge│
                              │ Detection │
                              └────┬─────┘
                                   │
STEP2                         ╱────▼────╲
                            ╱   Has a      ╲
              ◄────────────  predetermined  ───
              No            ╲ time period (T1)╱
                             ╲  elapsed?  ╱
                               ╲───┬───╱
                                 Yes │          ◄──────────┐
STEP3                         ╱──────▼──────╲              │
              ◄──────────────╱ Is a charge    ╲            │
              Yes            ╲  current detected?╱          │
                             ╲───────┬───────╱             │
                                   No │                    │
STEP4                         ╱──────▼──────╲              │
                            ╱ Predetermined   ╲────────────┘
                            ╲ battery capacity? ╱    No
                             ╲──────┬──────╱
                                 Yes │
STEP5              ┌─────────────────▼──────────────────┐
                   │Transition to full charge capacity  │
                   │correction mode                     │
                   ├────────────────────────────────────┤
                   │Limit charge current and discharge  │
                   │current to OA                       │
                   └─────────────────┬──────────────────┘
                                     │
            ┌───┐                ┌───▼───┐
            │ B │                │   A   │
            └───┘                └───────┘
```

FIG.4

FIG.5

FIG.6

## INTERNATIONAL SEARCH REPORT

| International application No. |
|---|
| PCT/JP2017/023552 |

**A. CLASSIFICATION OF SUBJECT MATTER**
*G01R31/36*(2006.01)i, *H01M10/44*(2006.01)i, *H01M10/48*(2006.01)i, *H02J3/32* (2006.01)i, *H02J3/38*(2006.01)i, *H02J7/00*(2006.01)i

According to International Patent Classification (IPC) or to both national classification and IPC

**B. FIELDS SEARCHED**

Minimum documentation searched (classification system followed by classification symbols)
G01R31/36, H01M10/44, H01M10/48, H02J3/32, H02J3/38, H02J7/00

Documentation searched other than minimum documentation to the extent that such documents are included in the fields searched
Jitsuyo Shinan Koho        1922-1996   Jitsuyo Shinan Toroku Koho   1996-2017
Kokai Jitsuyo Shinan Koho  1971-2017   Toroku Jitsuyo Shinan Koho   1994-2017

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y<br>A | JP 2012-145403 A  (Denso Corp.),<br>02 August 2012 (02.08.2012),<br>paragraphs [0001], [0009], [0023] to [0060];<br>fig. 1 to 5<br>& US 2012/0176092 A1<br>fig. 1 to 5; paragraphs [0003], [0011], [0021]<br>to [0079]<br>& CN 102590754 A | 1-2,5-6<br>3,7-9<br>4 |
| Y<br>A | JP 2015-202010 A  (Mitsubishi Electric Corp.),<br>12 November 2015 (12.11.2015),<br>paragraphs [0001], [0012], [0026] to [0028];<br>fig. 3<br>& DE 102014224608 A1    & CN 104977538 A | 3,7-9<br>1-2,4-6 |

☒ Further documents are listed in the continuation of Box C.      ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered    to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 15 September 2017 (15.09.17) | 26 September 2017 (26.09.17) |

| Name and mailing address of the ISA/ | Authorized officer |
|---|---|
| Japan Patent Office<br>3-4-3,Kasumigaseki,Chiyoda-ku,<br>Tokyo 100-8915,Japan | |
| | Telephone No. |

Form PCT/ISA/210 (second sheet) (January 2015)

**INTERNATIONAL SEARCH REPORT**

International application No.

PCT/JP2017/023552

C (Continuation).   DOCUMENTS CONSIDERED TO BE RELEVANT

| Category* | Citation of document, with indication, where appropriate, of the relevant passages | Relevant to claim No. |
|---|---|---|
| Y<br>A | JP 2014-102078 A  (Toyota Motor Corp.),<br>05 June 2014 (05.06.2014),<br>paragraphs [0001], [0008], [0019] to [0055];<br>fig. 1, 2<br>& US 2014/0139189 A1<br>fig. 1, 2; paragraphs [0003], [0012], [0029] to<br>[0065]<br>& CN 103823185 A | 7-9<br>1-6 |
| Y<br>A | JP 2015-118021 A  (Nissan Motor Co., Ltd.),<br>25 June 2015 (25.06.2015),<br>paragraphs [0001], [0004] to [0006], [0011] to<br>[0051], [0063] to [0064]; fig. 1, 2<br>(Family: none) | 9<br>1-8 |
| A | WO 2014/147899 A1  (Toyota Industries Corp.),<br>25 September 2014 (25.09.2014),<br>paragraphs [0001] to [0009], [0017], [0019] to<br>[0052]; fig. 1 to 12<br>& JP 2014-181924 A | 1-9 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2016025760 A